# EUROPEAN PATENT APPLICATION

(11) **EP 3 531 805 A1**
(43) Date of publication of application: **28.08.2019**
(21) Application number: 19159047.0
(22) Date of filing: 25.02.2019
(51) Int. Cl.: H05K 1/18

(54) **A METHOD FOR MANUFACTURING A LIGHTING DEVICE AND CORRESPONDING DEVICE**

(30) Priority: 27.02.2018 IT 201800003094
(71) Applicant: OSRAM GmbH, 80807 München (DE); Osram S.p.A. - Societa' Riunite Osram Edison Clerici, 20126 Milano (IT)
(72) Inventor: GRIFFONI, Mr. Alessio, I-30030 Fossò (Venezia) (IT); BALDO, Mr. Lorenzo, I-31040 Giavera del Montello (Treviso) (IT); GOBBO, Mr. Manuel, I-31022 Preganziol (Treviso) (IT); PEZZATO, Mr. Luigi, I-31000 Treviso (IT)
(74) Representative: Marchitelli, Mauro

(57) **Abstract**

A method for producing an elongated lighting device, comprising:
- providing a coated laminate (10) including a substrate (12) and a plurality of bus tracks (14, 15) on at least one side of the substrate (12),
- applying an insulating cover layer (20) to said coated laminate (10) on said bus tracks (14), wherein said insulating cover layer (20) has a plurality of openings (24, 46, 50) through which uncovered areas (14', 14") of said bus tracks (14) are exposed,
- forming electrical circuits (26) on said insulating cover layer (20) by electrically-conductive ink printing,
- interconnecting said electrical circuits (26) to uncovered areas (14') of said conductive tracks (14) through said openings (24, 46, 50), and
- applying electrically-powered light radiation sources (30) to selected areas of said electrical circuits (26).

## Description

### Technical field

The description refers to lighting devices.

One or more embodiments may refer to lighting devices that use electrically-powered solid-state light radiation sources, such as LED sources.

Particularly, one or more embodiments may concern a method for producing lighting devices.

One or more embodiments may refer to a corresponding lighting device.

### Technological background

Currently, the demand for highly customizable LED modules with very short development and delivery times is becoming increasingly widespread in the solid-state lighting market.

Linear and flexible LED modules may have different electrical units in parallel, including one or more LED chains and associated driver circuits, which result in a high power supply current. The high current influences the voltage drop along the long bus tracks (e.g. VDD and GND) of the LED modules and, therefore, also the functionality of the electrical units along the entire length of the LED module. Another important characteristic of these LED modules is the use of flexible printed circuit boards (FPCB) in reels, in order to obtain very long modules (for example, several meters) without bridges or connectors for interconnection of the electric units containing at least one LED chain. In addition, flexible printed circuit boards typically use single- or double-layer copper- or aluminum-clad laminates, which require different chemical processes, sometimes even dedicated equipment and lengthy set-up times in order to achieve the required design, especially when a *reel-to-reel* process is required instead of the more common *sheet-to-sheet* process. The fulfillment of all these requirements (*reel-to-reel* process, high length of LED modules with low pressure drop, simple and rapid customization) involves considerable difficulties.

Flexible and linear LED modules may consist of several single electrical units (SEU) connected in parallel along a strip. The electrical connection between the single electric units is obtained by at least two bus tracks (for example, VDD and GND). Multiple tracks are required for multi-channel modules such as, for example, RGB, RGBW, RGBA, RGBWA and TW. The conductive bus tracks extend along the entire strip forming the linear LED module.

One solution used for producing long linear LED modules is to use single-layer copper- or aluminum-clad laminates and to form wide and/or thick bus tracks in order to achieve a low electrical resistance of the tracks. However, in the event of a change in layout, this solution requires a complete overhaul of the entire flexible printed circuit, which entails the involvement of the printed circuit board manufacturers, which involves additional activities, costs and development times. On the other hand, the thickness of the conductive layer (copper or aluminum) is standardized and limited to 35 µm, 70 µm and 105 µm. The use of large thicknesses reduces the resolution of the tracks and limits the use of small electronic components and LEDs. Furthermore, a thick conductive layer reduces the overall flexibility of the module, which is a key feature of a flexible module. On the other hand, wider tracks lead to an increase in the width of the product, which can lead to disadvantages of installation and application for customers.

Another solution used to make long flexible LED modules is the use of double-layer copper or aluminum-clad laminates. Bus tracks can be formed on the lower conductive layer and can be connected to electrical circuits formed on the upper layer by means of electrically-conductive vertical interconnection accesses (VIA). However, in the case of a change of layout, this solution requires a complete overhaul of the entire flexible printed circuit, which entails the involvement of printed circuit manufacturers, requires additional activities and extra tools for creating vertical interconnection accesses, and long development times.

### Object and summary

One or more embodiments intend to contribute to overcoming the drawbacks outlined above.

According to one or more embodiments, this object can be achieved thanks to a method for producing lighting devices having the characteristics referred to in the following claims.

One or more embodiments may also refer to corresponding lighting devices.

The claims form an integral part of the technical disclosure provided here in relation to embodiments.

The proposed embodiments provide new methods for producing flexible double-sided and multi-layer printed circuits, with short development times using hybrid techniques which can be identified in the final product.

The common characteristics among the different embodiments can be:
- the formation of bus tracks in a copper mass for high currents (for example, ED, HD or RA) of copper-clad laminates (CCL); the bus tracks can have the same geometry independent of the electrical circuitry for supplying power to the light radiation sources;
- the formation of one or more insulating layers of conductive ink by means of screen printing or rotary printing in order to cover and isolate parts of the conductive buses; forming the dielectric layer is thus fast, and this layer can be easily and accurately aligned with the bus tracks in a more economical manner with respect to the lamination of a pre-punched coating;
- the circuitry for supplying the light radiation sources can be formed on an insulating cover layer applied above the bus tracks by means of printing, for example, screen printing, printed thick film (PTF) of conductive ink, or by chemical etching of single-sided flexible printed circuits boards (FPCB). This last possibility is faster and more customizable regarding double-sided printed circuits; however, the printing of conductive inks can have a better performance in terms of development time and customization as a new printing screen for a new layout can be available in a few days with reduced costs; furthermore, the ink printing of the circuitry for supplying power to the light radiation sources can be carried out on raw base material (for example, polyamide) instead of on flexible adhesive printed circuits which can inhibit the ink performance;
- creating the interconnections between the bus tracks and the power supply circuits of the light radiation sources, which carry low currents, can be carried out by:
- printing of continuous tracks of conductive ink on the dielectric layer and on the bus tracks with metal-based surface finishes such as Ag immersion or polymer-based finishes such as Organic Solderability Preservative (OSP);
- soldering/gluing of SMD jumpers (e.g. 0 Ω resistors) between the buses (with polymer-based surface finish such OSP) and the circuit;
- printing continuous tracks of electrically-conductive adhesive or solder paste between the LED circuits and the buses;
   these interconnection methods allow the use of VIAs to be avoided, which may require specific processes and increase the cost of the final plate.
- the *wire-to-board* connection as well as the soldering of connecting cables can be carried out on the bus tracks in order to obtain a more robust connection regarding the connection or soldering on PTF inks; the latter typically cannot carry high currents and are susceptible to abrasion during connector engagement.

### Brief description of the figures

One or more embodiments will be now described, purely by way of non-limiting example, with reference to the attached figures, wherein:
- Figures 1 to 4 are schematic plan views illustrating an embodiment of a method for producing linear lighting devices,
- Figures 5-9 are cross-sections according to the lines V-V, VI-VI, VII-VII, VIII-VIII and IX-IX of Figures 1-4, respectively,
- Figure 10 is a plan view illustrating another embodiment of a method for producing linear lighting devices,
- Figure 11 is a schematic cross-section along the line XI-XI of Figure 10,
- Figures 12 is a plan view illustrating another embodiment of a method for producing linear lighting devices,
- Figure 13 is a schematic cross-section along the line XIII-XIII of Figure 12,
- Figure 14 is a plan view illustrating another embodiment of a method for producing linear lighting devices,
- Figure 15 is a schematic cross-section along the line XV-XV of Figure 14,
- Figure 16 is a plan view illustrating another embodiment of a method for producing linear lighting devices,
- Figures 17 and 18 are schematic cross-sections according to the lines XVII-XVII and XVIII-XVIII, respectively, of Figure 16,
- Figure 19 is a plan view illustrating another embodiment of a method for producing linear lighting devices,
- Figure 20 is a cross-section along the line XX-XX of Figure 19,
- Figures 21, 22 and 23 are schematic plan views illustrating another embodiment for producing linear lighting devices,
- Figures 24, 25, 26 and 27 are schematic cross-sections according to the lines XXIV-XXIV, XXV-XXV, XXVI-XXVI and XXVII-XXVII, respectively of Figures 21-23,
- Figures 28 to 31 are schematic plan views illustrating another embodiment of a method for producing linear lighting devices, and
- Figures 32-36 are schematic cross-sections according to the lines XXXII-XXXII, XXXIII-XXXIII, XXXIV-XXXIV, XXXV-XXXV and XXXVI-XXXVI, respectively, of Figures 28-31.

It will be appreciated that, for clarity and simplicity of illustration, the various figures may not be reproduced on the same scale.

### Detailed description

The following description illustrates various specific details in order to provide a thorough understanding of various examples of embodiments. The embodiments can be implemented without one or more of the specific details, or with other methods, components, materials, etc. In other cases, known structures, materials, or operations are not shown or described in detail to avoid obscuring various aspects of the embodiments.

The reference to "an embodiment" in the context of the present description indicates that a particular configuration, structure or characteristic described in relation to the embodiment is included in at least one embodiment. Thus, sentences such as "in an embodiment", which may be present at various points in the present description, do not necessarily refer to exactly the same embodiment. Moreover, particular configurations, structures or characteristics can be combined in any suitable way in one or more embodiments.

The references used here are provided simply for convenience and, therefore, do not define the field of protection or the scope of the embodiments.

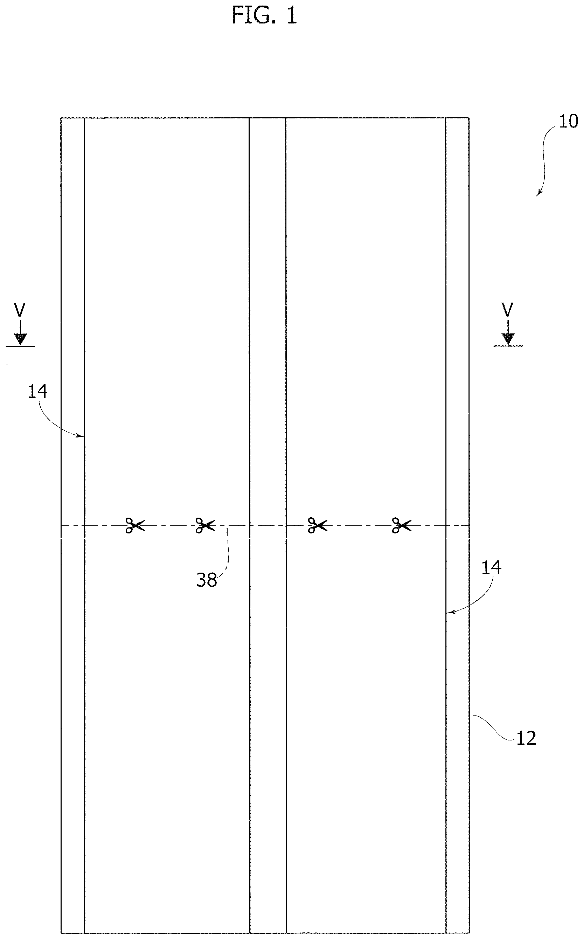

Figures 1 to 9 illustrate a first embodiment of a method for producing elongated lighting devices.

One or more embodiments may envisage that the elongated lighting devices are produced starting from a single-sided copper-clad laminate 10, for example, a copper-clad laminate (CCL). In one or more embodiments, the coated laminate 10 may be coated with a layer of metal other than copper, for example, of aluminum or its alloys. The copper-clad laminate 10 can be selected with different thicknesses of copper. In one or more embodiments, the copper-clad laminate 10 may comprise a substrate 12, for example, of a flexible insulating material. In one or more embodiments, the copper-clad laminate 10 can be etched in order to form two bus tracks 14, which can be formed by two continuous rectilinear strips, parallel to each other and elongated in the longitudinal direction. In one or more embodiments, the copper-clad laminate 10 may have an indefinite length in its longitudinal direction. In one or more embodiments, an adhesive layer 16 may be provided between the bus tracks 14 and the substrate 12. The bus tracks 14 may have a surface finish 18 on their upper surfaces.

The copper-clad laminate 10 can be selected with different thicknesses of the copper layer, even with particularly high thicknesses of the copper layer since a high definition etching is not required to form the bus tracks 14.

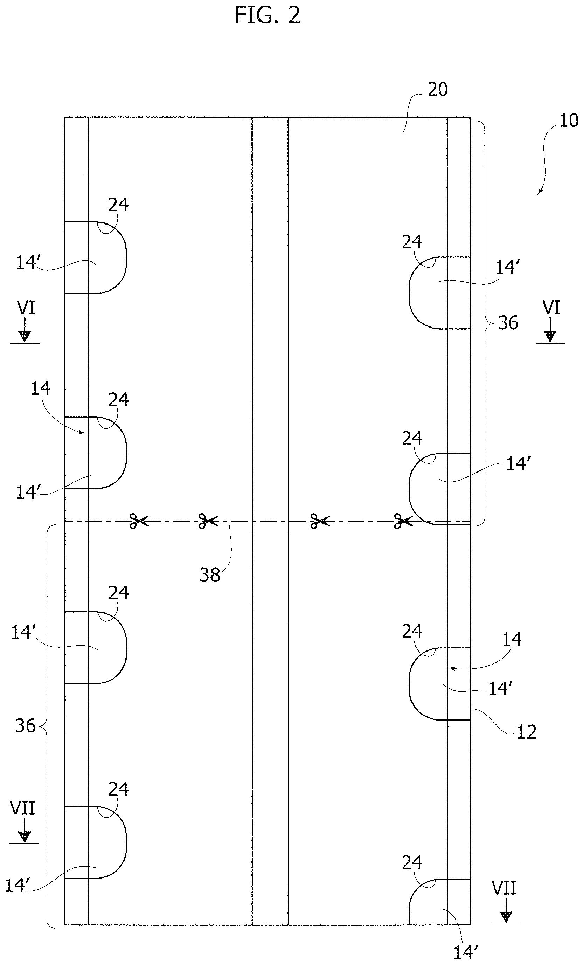

With reference to Figures 2, 6 and 7, in one or more embodiments, an insulating cover layer 20 can be applied to the copper-clad laminate 10 above the bus tracks 14.

In one or more embodiments, the insulating cover layer 20 can be laminated onto the bus tracks 14 by means of an adhesive 22.

In one or more embodiments, the insulating cover layer 20 may be a dielectric (hardened) ink layer printed on the bus tracks 14.

In one or more embodiments, the insulating cover layer 20 may have a plurality of openings through which uncovered areas 14' of the bus tracks 14 can be exposed. In one or more embodiments, the openings may be formed of windows 24 formed on opposite longitudinal edges of the insulating cover layer 20.

In one or more embodiments, the windows 24 can be formed during dielectric ink printing.

In one or more embodiments, the windows 24 can be formed by punching or laser cutting. In one or more embodiments, the cover layer 20 can be formed of a flexible material, for example, polyamide.

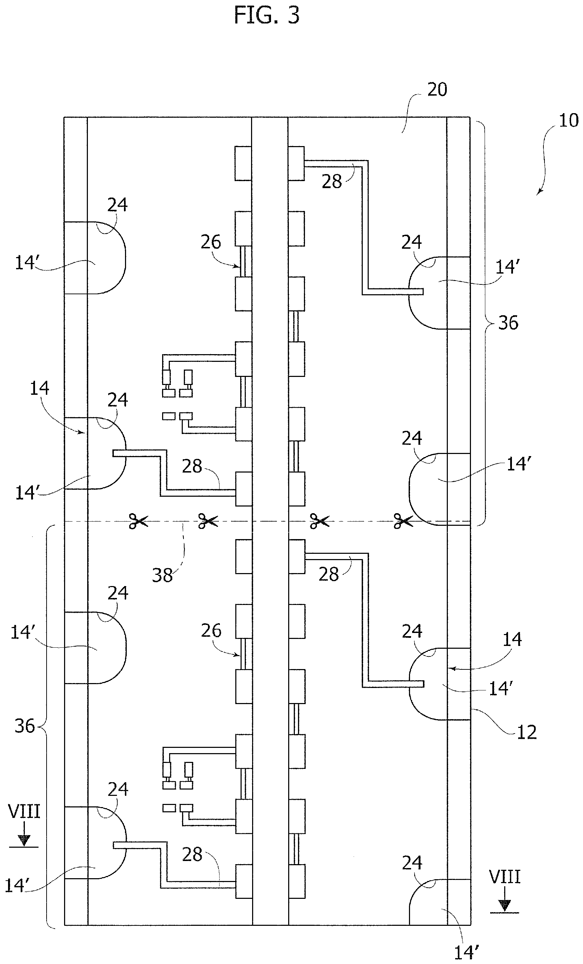

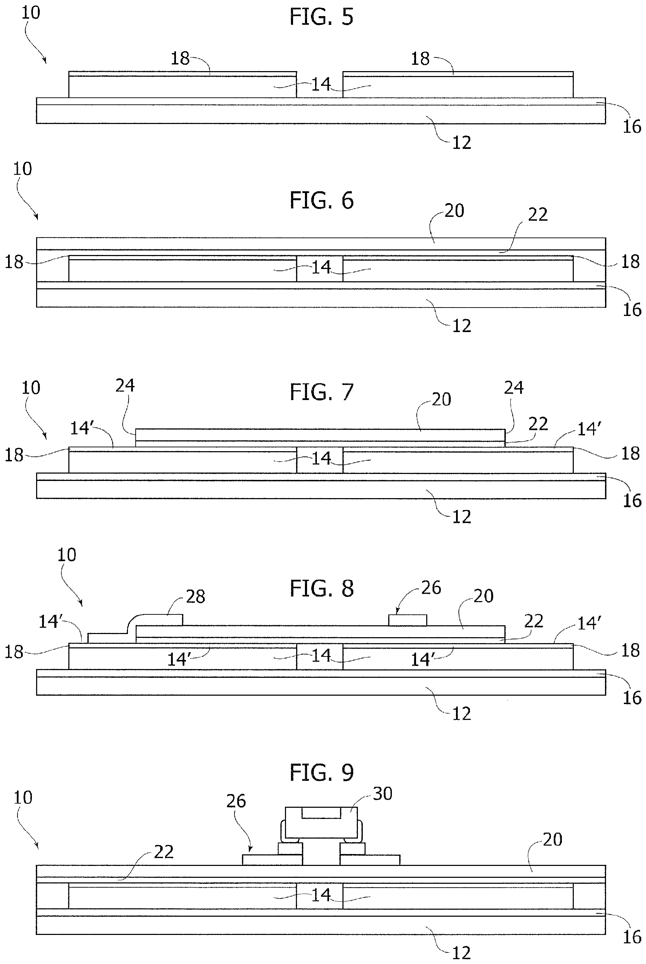

With reference to Figures 3 and 8, in one or more embodiments, electrical circuits 26 can be formed on the insulating cover layer 20 by means of electrically-conductive ink printing. The electrical circuits 26 can be printed by screen printing. In one or more embodiments, the electrical circuits 26 can be formed by the technology known as *Printed Thick Film* (PTF). The electrical circuits 26 may have selected areas for assembling electrically-powered light radiation sources and electronic components for powering and driving the light radiation sources.

In one or more embodiments, the electrical circuits 26 printed on the insulating cover layer 20 can be interconnected to uncovered areas 14' of the bus tracks 14, in order to electrically connect the printed electrical circuits 26 (located on the outer face of the insulating cover layer 20) to the bus tracks 14 located on the opposite side of the insulating cover layer 20.

In one or more embodiments, the interconnection between the printed electrical circuits 26 and the uncovered areas 14' of the bus tracks 14 can be obtained by branches of printed conductive ink 28, which extend through the openings, for example, through the windows 24, of the insulating cover layer 20, as illustrated, for example, in Figures 3, 4 and 8. As illustrated in Figure 8, in one or more embodiments, each branch of conductive ink 28 can extend through a step formed between the respective uncovered area 14' and the upper surface of the insulating cover layer 20.

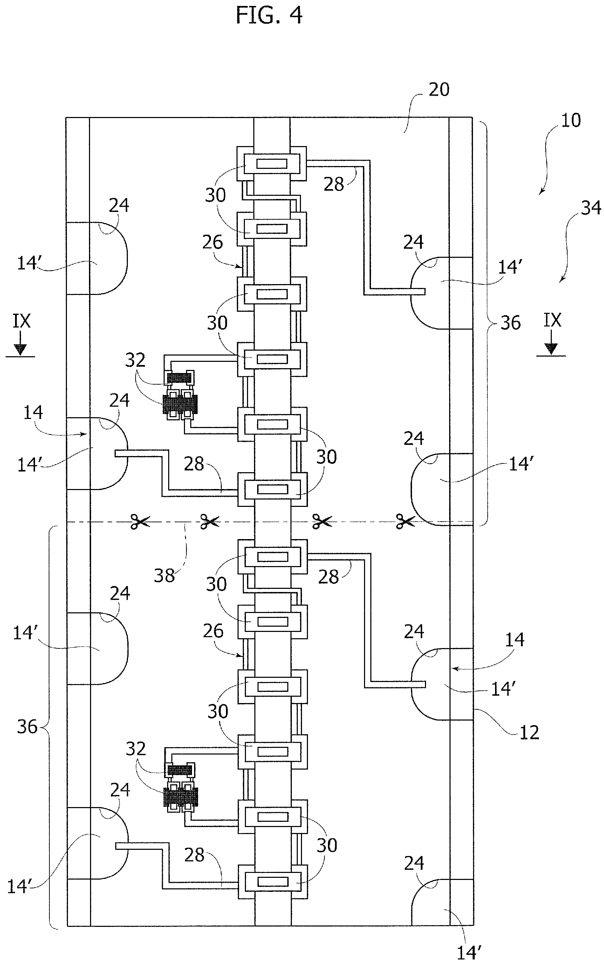

With reference to Figures 4 and 9, in one or more embodiments, a plurality of electrically-powered light radiation sources 30 can be applied to selected areas of the electrical circuits 26. In one or more embodiments, the electrically-powered light radiation sources can be solid-state light radiation sources, for example, LEDs. In one or more embodiments, electronic power supply and driving components 32 can be applied to selected areas of the printed electrical circuits 26. In one or more embodiments, the electrically-powered light radiation sources 30 and/or the electronic power supply and driving components 32 can be electrically connected to the electrical circuits 26 by electrically-conductive adhesive (ECA) or solder pastes.

One or more embodiments allow linear and flexible lighting devices 34 elongated in a longitudinal direction to be obtained. The linear lighting devices 34 can be subdivided into single electric units (SEU) 36 connected in parallel to each other to the bus tracks 14. The linear lighting device 34 can be cut transversely along cutting lines 38 located between single electric units 36 adjacent to each other. Electrical connectors can be applied to single electrical units 34 with contact pins pressed into contact with the bus tracks 14.

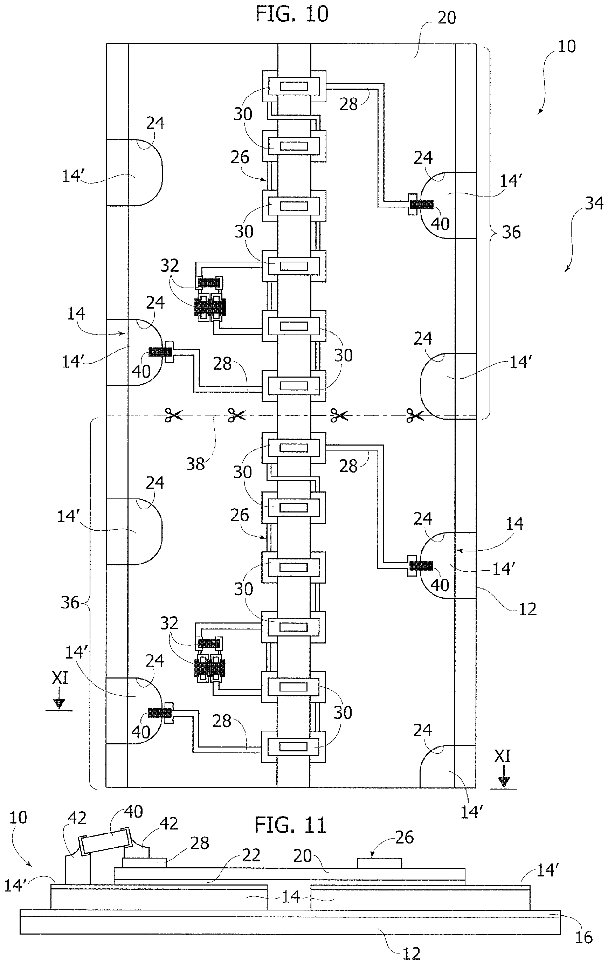

With reference to Figures 10 and 11, in one or more embodiments, the branches 28 of electrically-conductive ink of the electrical circuits 26 can be interconnected to the uncovered areas 14' of the bus tracks 14 by conductive jumpers 40 connected to the uncovered areas 14' and to the branches 28 by electrically-conductive adhesive (ECA) or solder paste 42 (Figure 11). The conductive jumpers 40, as well as the light radiation sources 30 and the electronic components 32, can be applied according to SMD technology. Connecting formations 42 of electrically-conductive adhesive or of solder paste can be deposited on the uncovered areas 14' of the bus tracks 14 by means of stencil printing or screen printing, or by using SMD solder bricks.

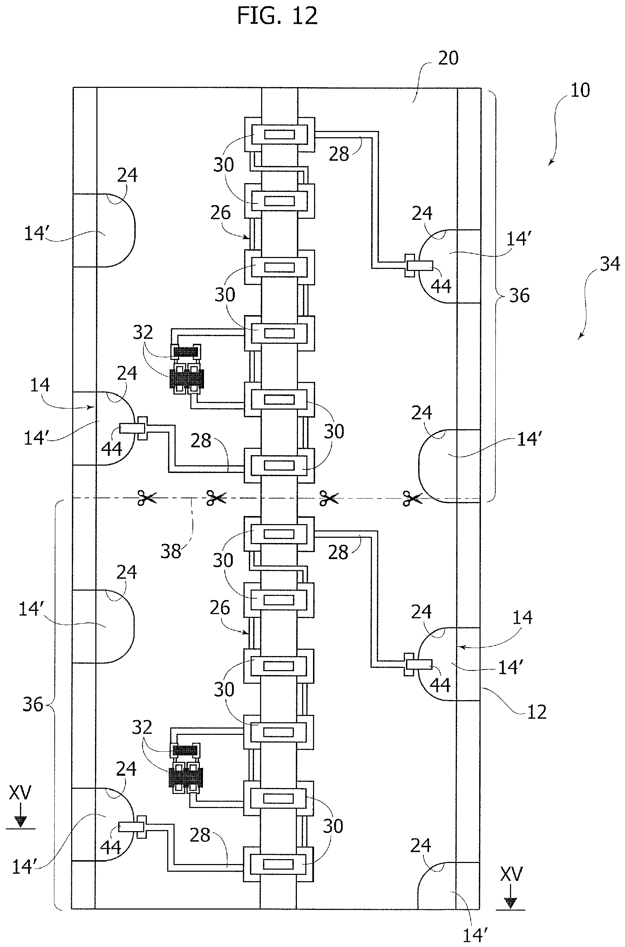

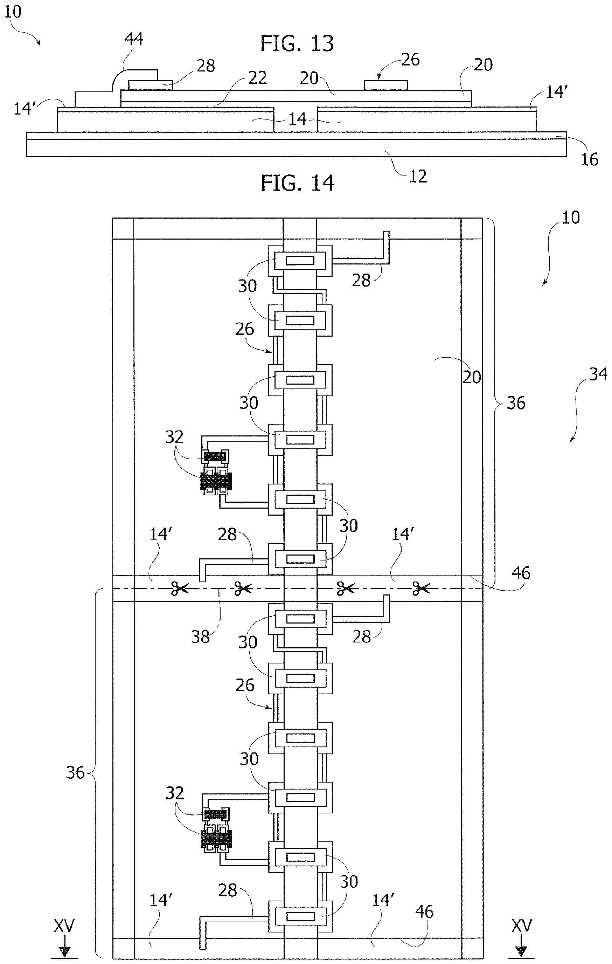

With reference to Figures 12 and 13, in one or more embodiments, the interconnection between the electrical circuits 26 printed on the insulating cover layer 20 and the bus tracks 14 can be carried out by printing one or more electrically-conductive adhesive tracks 44 astride the insulating cover layer 20 and the uncovered areas 14' of the bus tracks 14. In one or more embodiments, a thick layer of electrically-conductive adhesive (e.g. thicker than 50 µm) can be printed. In one or more embodiments, printing of a thick layer of electrically-conductive adhesive can be carried out with a mesh screen with a thick layer of emulsion, or by stencil printing. In one or more embodiments, the electrically-conductive adhesive layer 44 can be much thicker than the conductive ink used for printing the electrical circuit 26 (which may typically be in the range of 10 µm-30 µm), allowing a more robust interconnection between the printed electrical circuits 26 and the bus tracks 14. In one or more embodiments, the electrically-conductive adhesive 44 can adhere not only to metal materials (such as conductive inks and to the copper mass with possible surface finishes), but also to the material forming the insulating cover layer 20. This characteristic can prevent the printing of the conductive ink branches 28 near the edges of the windows 24 of the insulating cover layer 20, which may lead to simplification of the printing process of the electrically-conductive ink forming the electrical circuits 26.

In one or more embodiments, conductive tracks for interconnecting the electrical circuits 26 of electrically-conductive ink and the uncovered areas 14' of the bus tracks 14 may be formed of solder paste. In one or more embodiments, the electrical circuits 26 may have some tracks (which may consist of solderable conductive ink) printed in the immediate vicinity of the edges of the openings 24 of the insulating cover layer 20, since the solder paste does not bind to the insulating cover layer material 20. This method allows soldering of the solder paste used for interconnection, by means of spot soldering, hot rod or manual soldering (in the latter case, low temperature soldering may be taken into consideration, since the interconnection areas do not typically require high operating temperatures). Typically, solder pastes may be cheaper than electrically-conductive adhesives.

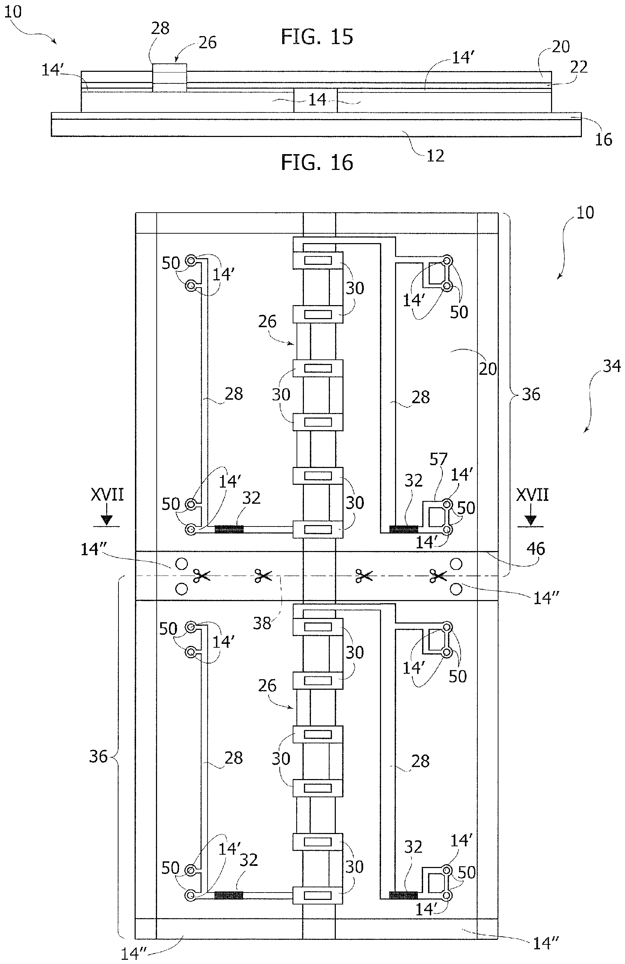

With reference to Figures 14 and 15, in one or more embodiments, the openings of the insulating cover layer 20 can be formed by transverse edge-to-edge through-grooves 46 located between single electrical units 36 adjacent to each other. In one or more embodiments, the uncovered areas 14' of the bus tracks 14 are located between two parallel edges of each transverse edge-to-edge groove 46. The cutting lines 38 that separate the single electrical units 36 from each other can be in the center of the transverse edge-to-edge grooves 46. The interconnection between the electrical circuits 26 and the uncovered areas 14' can be carried out by means of electrically-conductive ink branches 28 printed on the insulating cover layer 20 and which extend partly on respective uncovered areas 14' of the bus tracks 14. In one or more embodiments, the interconnection between the branches 28 of the electrical circuits 26 with the uncovered areas 14' of the bus tracks 14 can be carried out by means of SMD jumpers as described in relation to Figures 10 and 11, or by electrically-conductive adhesives or solder pastes, as described in relation to Figures 12 and 13. In one or more embodiments, the uncovered areas 14' of the bus tracks 14 which are not covered by the insulating cover layer can be used for connecting connectors and/or for soldering cables.

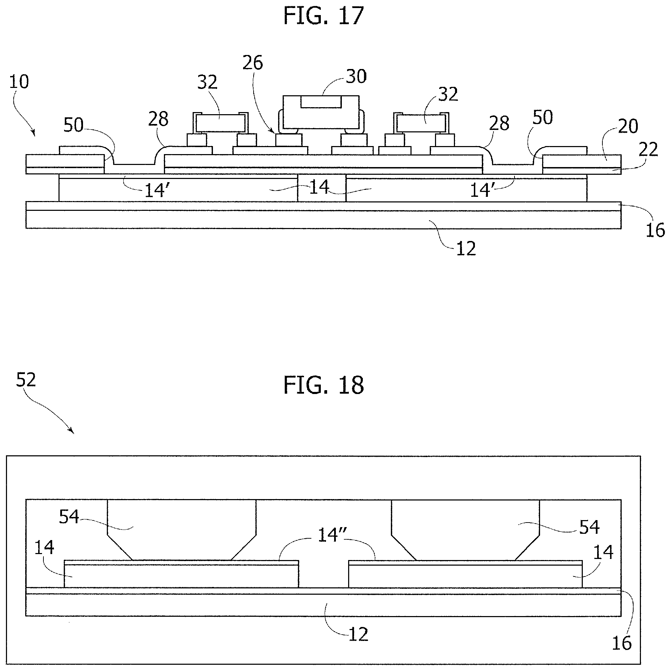

With reference to Figures 16 and 17, in one or more embodiments, the openings of the insulating cover layer 20 through which uncovered areas 14' of the bus tracks 14 are exposed can be formed by through-holes 50 formed, for example, by punching the insulating cover layer 20. The through-holes 50 of the insulating cover layer 20 can form respective vertical interconnection accesses (VIA). In one or more embodiments, branches 28 of electrically-conductive ink printed on the insulating cover layer 20 may extend through the through-holes 50 to establish electrical interconnection of the electrical circuits 26 with the uncovered areas 14' of the bus tracks 14 through the through-holes 50.

In one or more embodiments, the insulating cover layer 20 may comprise transverse edge-to-edge grooves 46 which leave uncovered areas 14" of the bus tracks 14 exposed between single electrical units 36 adjacent to each other. In one or more embodiments, the second uncovered areas 14" can be used for connecting connectors 52 (Figure 18). In one or more embodiments, a connector 52 may have contact pins 54 pressed into contact with uncovered areas 14" of the bus tracks 14.

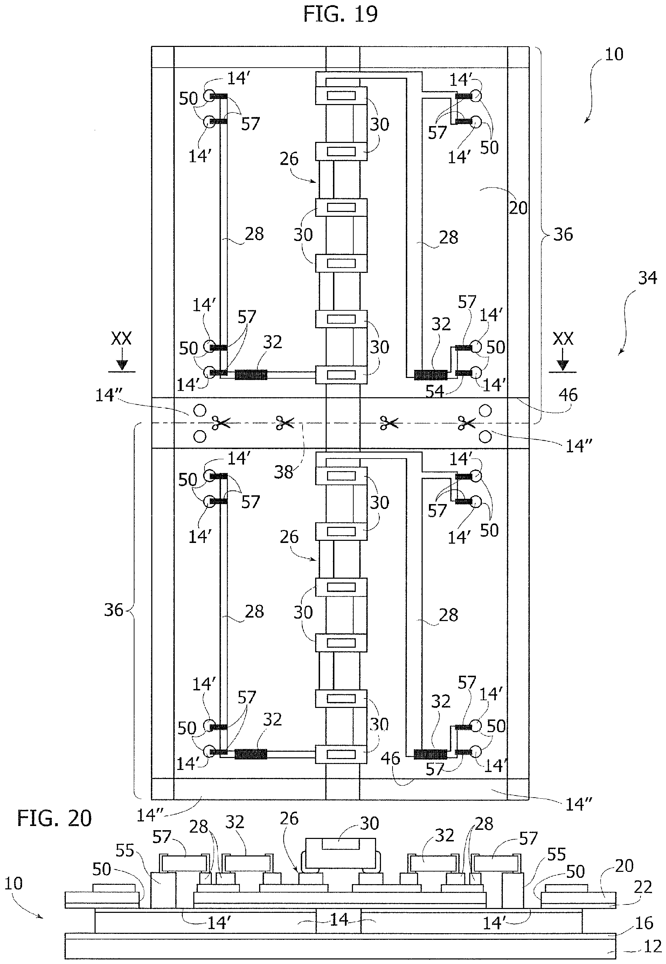

With reference to Figures 19 and 20, in one or more embodiments, conductive pins 55 which extend through the through-holes 50 of the insulating cover layer 20, can be formed. In one or more embodiments the conductive pins 55 can be formed from electrically-conductive adhesive (ECA) or solder paste deposited on the uncovered areas 14' of the bus tracks 14 and which extend through the holes 50 of the insulating cover layer 20. The conductive pins 55 can be formed by screen printing or using SMD solder bricks. In one or more embodiments, the printed conductive ink branches 28 on the insulating cover layer 20 can be interconnected to the conductive pins 55 by means of SMD jumpers 57. In one or more embodiments, the height of the conductive pins 55 may be such that the SMD jumpers 57 are arranged in a nearly flat position.

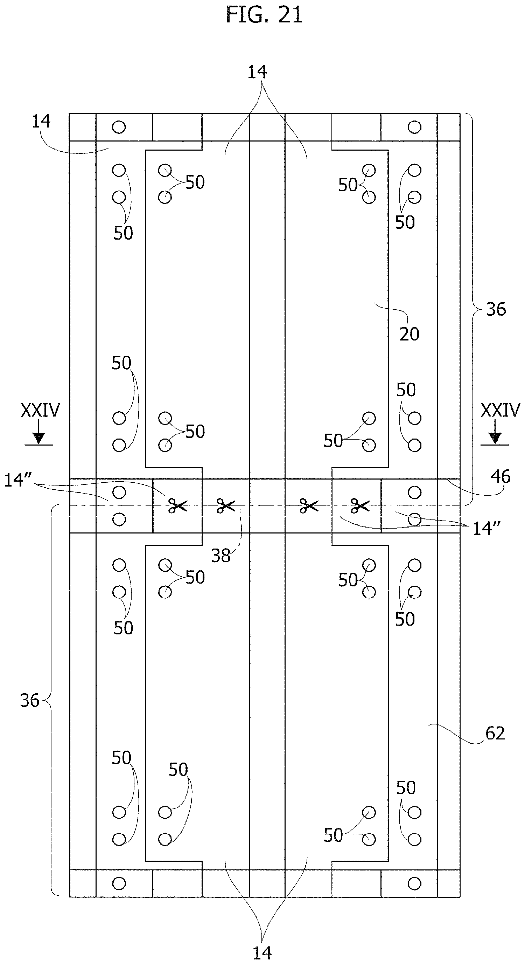

With reference to Figures 21-26, in one or more embodiments, the linear lighting devices can be produced using a double-sided coated laminate 10. In one or more embodiments, the double-sided coated laminate 10 may comprise an insulating support 12, one or more bus tracks 14 located on a first face of the insulating support 12 and one or more bus tracks 15 located on a second face of the insulating support 12 opposite the first face. Adhesive layers 16 may be arranged on opposite sides of the insulating support 12. The bus tracks 14, 15 on opposite faces of the insulating support 12 can be connected to each other by means of vertical interconnection accesses 60 (VIA), for example, of the PTH (Plated Through-Hole) type.

In one or more embodiments, a first insulating cover layer 20 can be applied to the double-sided coated laminate 10 on the first bus tracks 14. In one or more embodiments, a second insulating cover layer 21 can be applied to the coated laminate 10 on the second bus tracks 15. In one or more embodiments, the first insulating cover layer 20 may have a plurality of openings through which uncovered areas of the bus tracks 14 are exposed. In one or more embodiments, the openings of the first insulating cover layer 20 can be formed by through-holes 50 obtained, for example, by means of punching. In one or more embodiments, the first insulating cover layer 20 may comprise transverse edge-to-edge grooves 46 located between successive single electrical units 36.

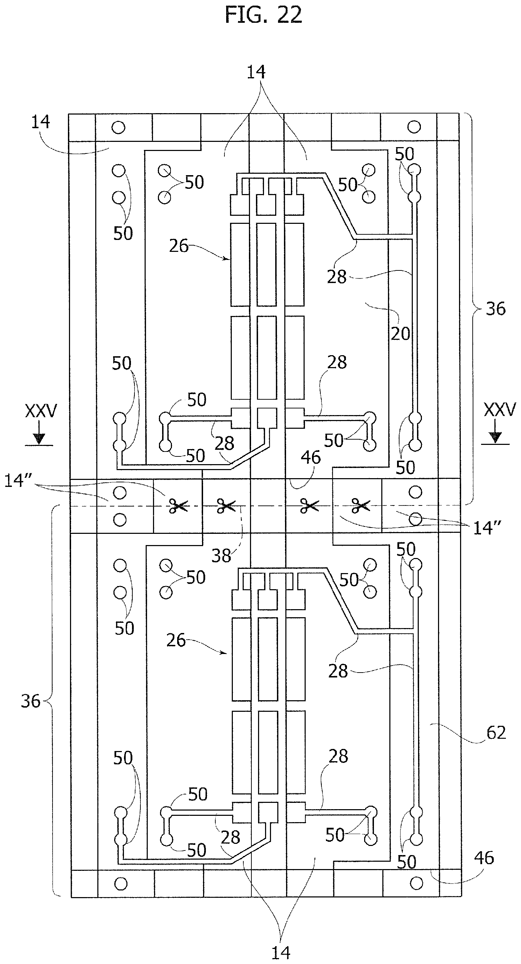

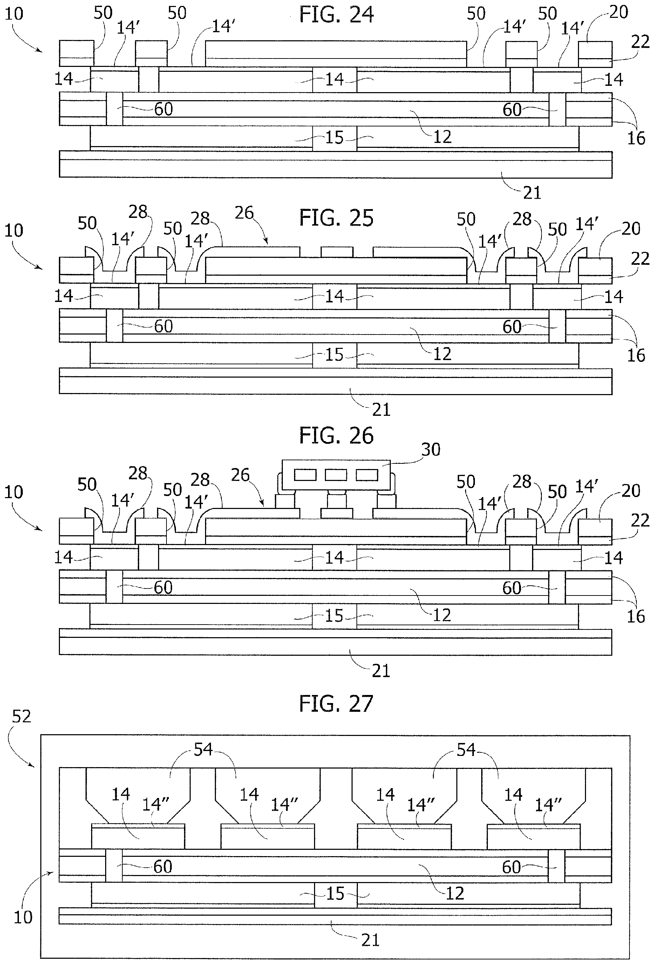

With reference to Figures 22 and 25, electrical circuits 26 can be formed on the insulating cover layer 20 by means of electrically-conductive ink printing. The electrical circuits 26 may comprise branches 28 for interconnection to the first bus tracks 14. In one or more embodiments, the conductive ink forming the branches 28 may extend through the holes 50 of the insulating cover layer 20 to establish an electrical connection with the first bus tracks 14 through the holes 50.

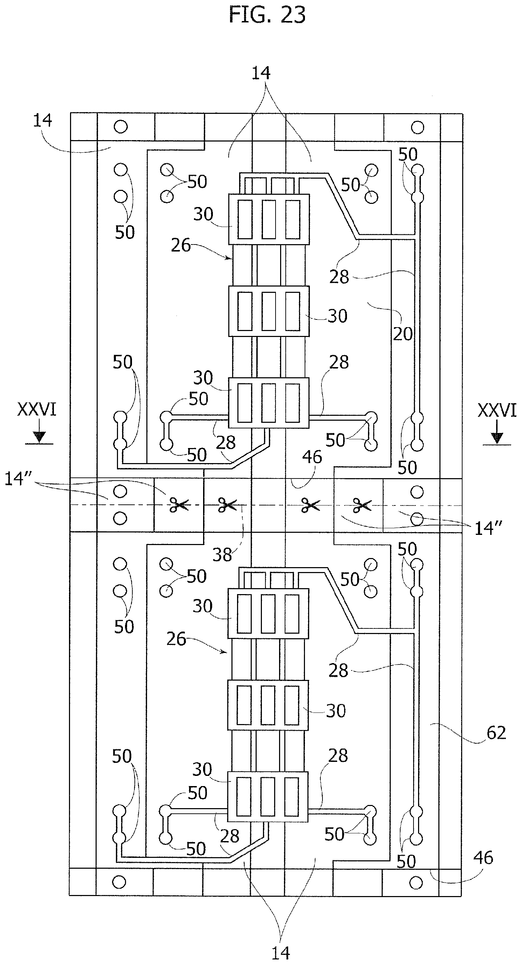

With reference to Figures 23 and 26, electrically-powered light radiation sources 30 can be applied to selected areas of the electrical circuits 26, for example, by electrically-conductive adhesives or solder pastes.

With reference to Figure 27, in one or more embodiments, the single electric units 36 obtained by transverse cutting of the lighting device 34 can be connected to respective connectors 52 provided with contact pins 54 which act on second uncovered areas 14" of the first bus tracks 14.

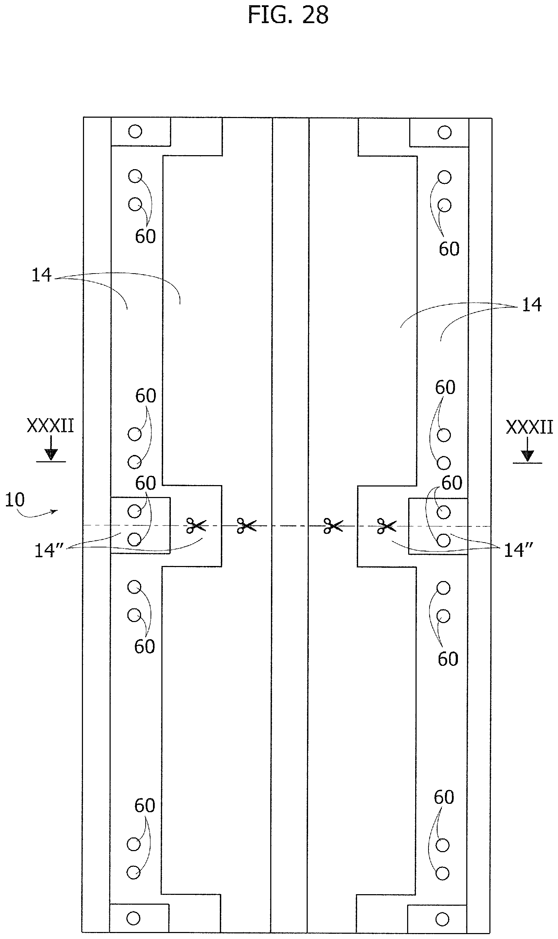

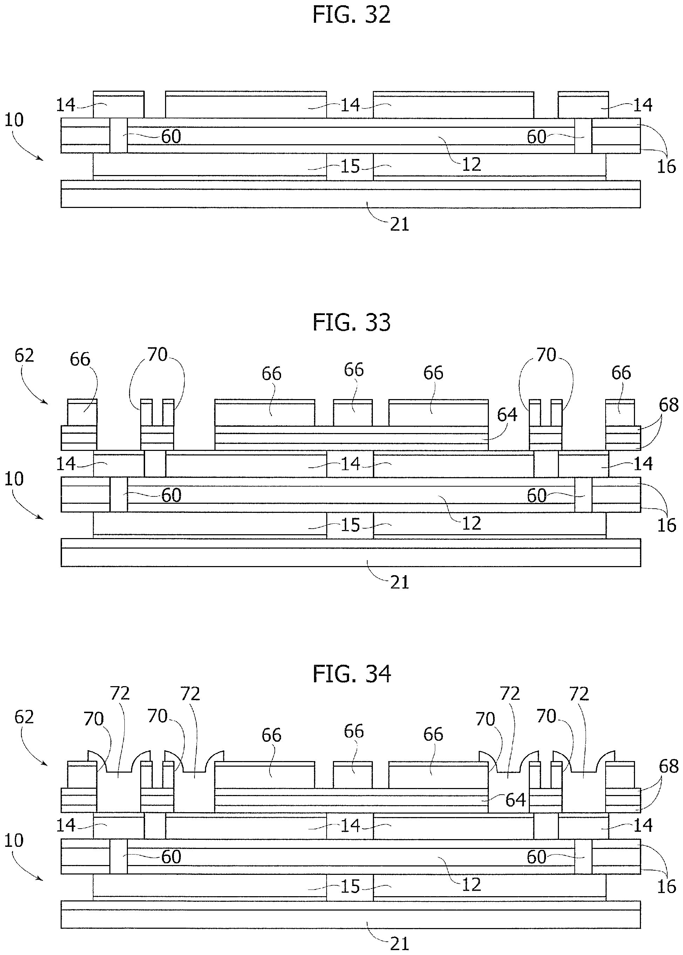

With reference to Figures 28 and 32, one or more embodiments may provide a double-sided coated laminate 10 including a substrate 12, one or more bus tracks 14 applied to the first face of the substrate 12 and one or more bus tracks 15 applied to the second face of the substrate 12 opposite the first face. Adhesive layers 16 may be provided on opposite sides of the support 12. The first bus tracks 14 can be interconnected to the second bus tracks 15 by means of vertical interconnection accesses (VIA) 60, for example, of the PTH (Plated Through-Hole) type. With reference to Figure 32, an insulating cover layer 21 can be applied to the double-sided coated laminate 10 on the second bus tracks 15.

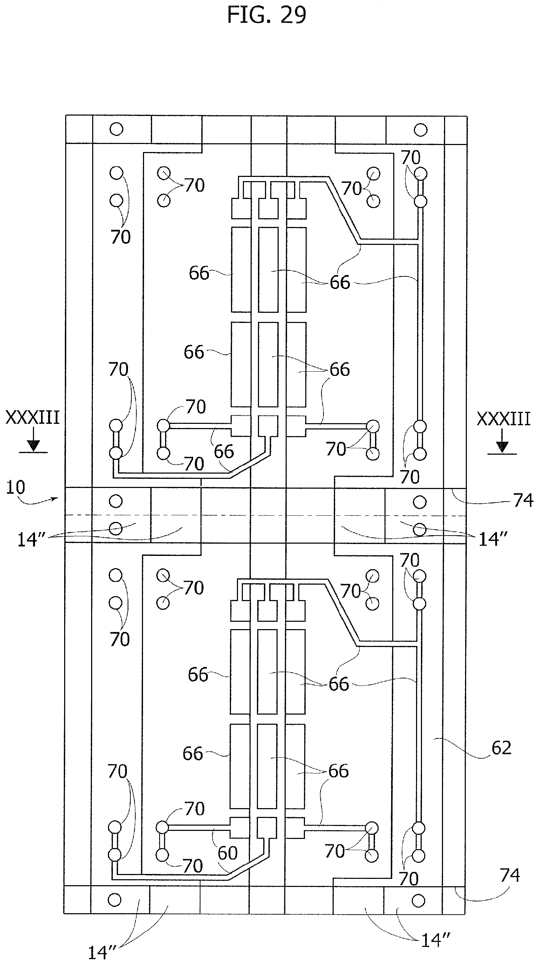

With reference to Figures 29 and 33, in one or more embodiments, a single-sided flexible printed circuit 62 can be applied to the first bus tracks 14 of the coated laminate 10. In one or more embodiments, the single-sided flexible printed circuit 62 may comprise a support 64 and conductive tracks 66. Adhesive layers 68 may be provided on opposite faces of the support 64. The single-sided flexible printed circuit 62 may comprise through-holes 70 forming vertical interconnections accesses (VIA) facing respective first bus tracks 14 of the coated laminate 10.

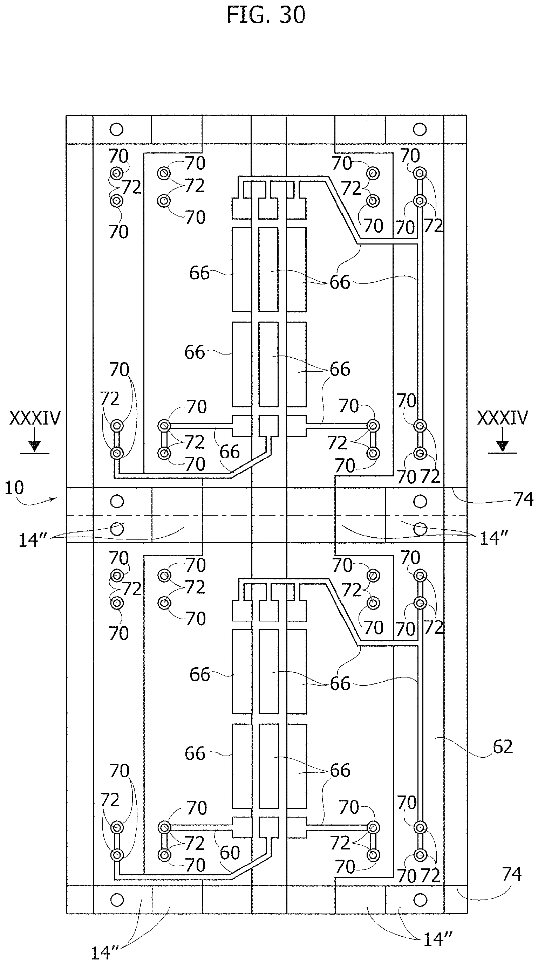

With reference to Figures 30 and 34, in one or more embodiments, conductive ink 72 can be printed inside the holes 70 to form an electrical interconnection between the conductive tracks 66 of the single-sided flexible printed circuit 62 and the first bus tracks 14 of the coated laminate 10.

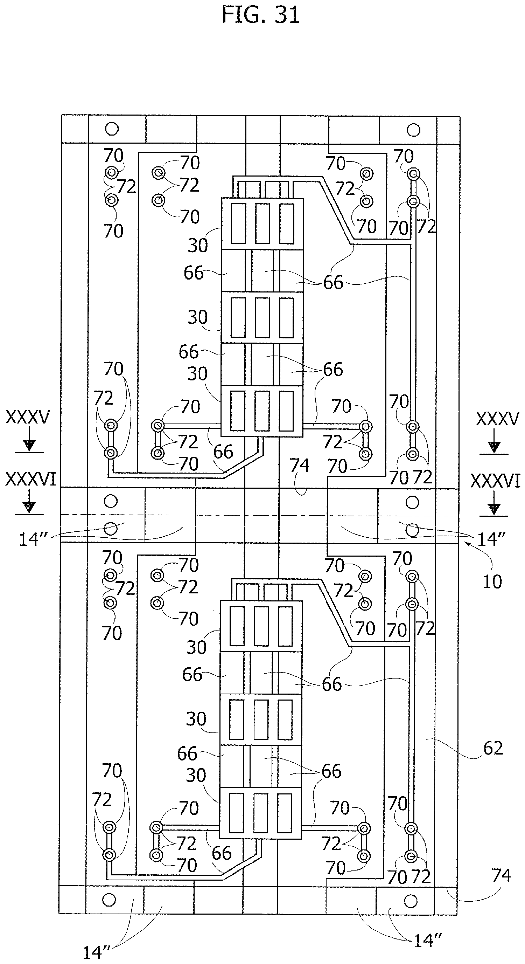

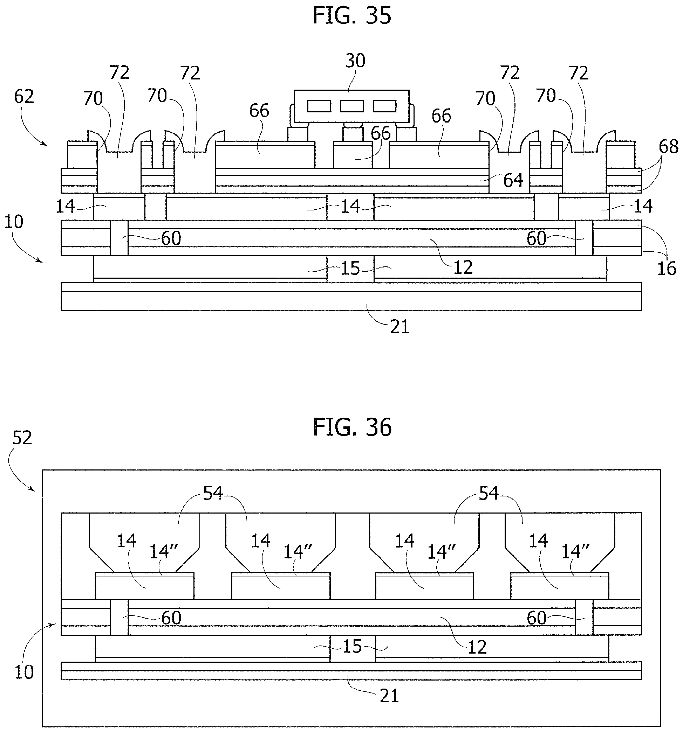

With reference to Figures 31 and 35, in one or more embodiments, electrically-powered light radiation sources 30 can be applied to the conductive tracks 66 of the single-sided flexible printed circuit 62 by means of an electrically-conductive adhesive or solder paste.

In one or more embodiments, the flexible single-sided printed circuit 62 can have transverse edge-to-edge through-grooves 74 which leave uncovered areas 14" of the first bus tracks 14 exposed. In one or more embodiments, the uncovered areas 14" and the first bus tracks 14 of the single electric units 36 can be engaged by respective connectors 52 having contact pins 54 pressed into contact with the uncovered areas 14" of the first bus tracks 14.

One or more embodiments may offer one or more of the following advantages:
- possibility of quickly and economically managing new products or customizing flexible and linear LED lighting modules without incurring problems due to high electrical resistance;
- possibility of reducing the electrical resistance thanks to the possibility of providing wide bus tracks obtained from a dedicated copper layer;
- possibility of introducing changes to the flexible printed circuits by the assembler of the electronic components without involving the flexible printed circuit supplier;
- possibility of managing different layouts or circuits on a single flexible printed circuit without modifying the copper-clad laminate (CCL) which constitutes the most expensive part of the entire flexible printed circuit due to the copper etching method;
- possibility of increasing the standardization of the copper-clad laminates;
- possibility of using copper-clad laminates based on inexpensive adhesives without compromising the ink;
- possibility of making holes for vertical interconnection accesses using a modular approach (for example, with a smaller pitch than the minimum length of the single electrical units), which leads to the use of a single punching tool for multiple circuit layouts, LED-to-LED pitch and lengths of single electric units;
- possibility of designing narrow flexible printed circuit strips that allow narrow LED modules to be obtained.

One or more embodiments may, therefore, relate to a method for producing an elongated lighting device, which may comprise:
- providing a coated laminate (e.g. 10) including a substrate (e.g. 12) and a plurality of bus tracks (e.g. 14, 15) on at least one side of the substrate (e.g. 12),
- applying an insulating cover layer (e.g. 20) to said coated laminate (e.g. 10) on said bus tracks (e.g. 14), wherein said insulating cover layer (e.g. 20) has a plurality of openings (e.g. 24, 46, 50) through which uncovered areas (e.g. 14', 14") of said bus tracks (e.g. 14) are exposed,
- forming electrical circuits (e.g. 26) on said insulating cover layer (e.g. 20) by electrically-conductive ink printing,
- interconnecting said electrical circuits (e.g. 26) to uncovered areas (e.g. 14') of said bus tracks (e.g. 14) through said openings (e.g. 24, 46, 50), and
- applying electrically-powered light radiation sources (e.g. 30) to selected areas of said electrical circuits (e.g. 26).

In one or more embodiments the method may comprise crosswise cutting of said coated laminate (e.g. 10) to form single electrical units (e.g. 36) and apply to said single electrical units (e.g. 36) respective electrical connectors (e.g. 52) with contact pins (e.g. 54) in contact with uncovered areas (e.g. 14') of said bus tracks (e.g. 14).

In one or more embodiments, said openings of said insulating cover layer (20) may comprise:
- windows (e.g. 24) formed on the side edges of the insulating cover layer (e.g. 20);
- edge-to-edge transverse through-grooves (e.g. 46);
- through-holes (e.g. 50) forming vertical interconnection accesses.

In one or more embodiments, said electrical circuits (e.g. 26) can be electrically-connected to said uncovered areas (e.g. 14') of said bus tracks (e.g. 14) by conductive ink branches (e.g. 28) extending over said uncovered areas (e.g. 14') of said bus tracks (e.g. 14) through said openings (e.g. 24, 46, 50) .

In one or more embodiments, said electrical circuits can be electrically-connected to said uncovered areas (e.g. 14') of said bus tracks (e.g. 14) by means of SMD jumpers (e.g. 40) connected between branches (e.g. 28) of printed conductive ink on said insulating cover layer (e.g. 20) and connecting formations (e.g. 42) of electrically-conductive adhesive or solder paste applied to said uncovered areas (e.g. 14') of said bus tracks (e.g. 14).

In one or more embodiments, said electrical circuits (e.g. 26) can be electrically-connected to said uncovered areas (e.g. 14') of said bus tracks (e.g. 14) by means of electrically-conductive adhesive tracks (e.g. 44) printed between respective uncovered areas (e.g. 14') of said bus tracks (e.g. 14) and respective branches of electrically-conductive ink (e.g. 28) printed on said insulating cover layer (e.g. 20).

In one or more embodiments said coated laminate (e.g. 10) may be a single-sided laminate.

In one or more embodiments said coated laminate (e.g. 10) may be a double-sided laminate including a substrate (e.g. 12), one or more first bus tracks (e.g. 14) formed on the first face of said substrate (e.g. 12), and one or more second bus tracks (e.g. 15) formed on the second face of said substrate (e.g. 12) opposite said first face.

In one or more embodiments, said first and second bus tracks (e.g. 14, 15) can be interconnected with each other by means of vertical interconnection accesses (e.g. 60).

One or more embodiments may relate to a method for producing an elongated lighting device, comprising:
- providing a coated laminate (e.g. 10) including a substrate (e.g. 12) and a plurality of bus tracks (e.g. 14, 15) on at least one side of said substrate (e.g. 12),
- applying a single-sided flexible printed circuit (e.g. 62) to said coated laminate (e.g. 10) on said bus tracks (e.g. 14), wherein said single-sided flexible printed circuit (e.g. 62) comprises an insulating support (e.g. 64) and a plurality of conductive tracks (e.g. 66), and wherein said single-sided flexible printed circuit (e.g. 62) comprises a plurality of through-holes (e.g. 70) forming vertical interconnection accesses,
- interconnecting said conductive tracks (e.g. 66) of said single-sided flexible printed circuit (e.g. 62) to said bus tracks (e.g. 14) of said coated laminate (e.g. 10) by conductive ink (e.g. 72) printed through said through-holes (e.g. 70) of said single-sided flexible printed circuit (e.g. 62), and
- applying electrically-powered light radiation sources (e.g. 30) to selected areas of said conductive tracks (e.g. 66) of said single-sided flexible printed circuit (e.g. 62).

One or more embodiments may relate to a lighting device comprising:
- a coated laminate (e.g. 10) including a substrate (e.g. 12) and a plurality of bus tracks (e.g. 14) on at least one side of the substrate (e.g. 12),
- an insulating cover layer (e.g. 20) applied to the coated laminate (e.g. 10) on said bus tracks (e.g. 14), wherein said insulating cover layer (e.g. 20) has a plurality of openings (e.g. 24, 46, 50) through which uncovered areas (e.g. 14') of said bus tracks (e.g. 14) are exposed,
- an electrical circuit (e.g. 26) of electrically-conductive ink printed on said insulating cover layer (e.g. 20) and interconnected with said uncovered areas (e.g. 14') of said bus tracks (e.g. 14) through these openings (e.g. 24, 46, 50), and
- a plurality of electrically-powered light radiation sources (e.g. 30) applied to selected areas of said electrical circuit (e.g. 26).

One or more embodiments may relate to a lighting device, comprising:
- a coated laminate (e.g. 10) including a substrate (e.g. 12) and a plurality of bus tracks (e.g. 14) on at least one side of the substrate (e.g. 12),
- a single-sided flexible printed circuit (e.g. 62) applied to the coated laminate (e.g. 10) on said bus tracks (e.g. 14), wherein said single-sided flexible printed circuit (e.g. 62) comprises a substrate (e.g. 64) and a plurality of conductive tracks (e.g. 66) and wherein said single-sided flexible printed circuit (e.g. 62) comprises a plurality of through-holes (e.g. 70) forming vertical interconnection accesses,
- electrical connecting formations (e.g. 72) of electrically-conductive ink printed inside said through-holes (e.g. 70), which electrically connect said conductive tracks (e.g. 66) of said single-sided flexible printed circuit (e.g. 62) to said bus tracks (e.g. 14) of said coated laminate (10), and
- a plurality of electrically-powered light radiation sources (e.g. 30) connected to selected areas of said conductive tracks (e.g. 66) of said single-sided flexible printed circuit (e.g. 62).

Without prejudice to the underlying principles of the invention, the details of construction and the embodiments may vary, even significantly, with respect to those illustrated here, purely by way of non-limiting example, without departing from the scope of the invention.

This field of protection is defined by the attached claims.

**LIST OF REFERENCE SIGNS**

| | |
|---|---|
| copper-clad laminate | 10 |
| substrate | 12 |
| bus tracks | 14 |
| adhesive layer | 16 |
| surface finish | 18 |
| insulating cover layer | 20 |
| adhesive | 22 |
| uncovered areas | 14' |
| windows | 24 |
| electrical circuits | 26 |
| printed conductive ink branches | 28 |
| light radiation sources | 30 |
| electronic components | 32 |
| linear lighting device | 34 |
| single electrical units | 36 |
| cutting line | 38 |
| conductive jumpers | 40 |
| solder paste | 42 |
| electrically-conductive adhesive tracks | 44 |
| edge-to-edge transverse through-grooves | 46 |
| through-holes | 50 |
| connectors | 52 |
| contact pins | 54 |
| conductive pins | 55 |
| SMD jumpers | 57 |
| vertical interconnection accesses | 60 |
| flexible single-sided printed circuit | 62 |
| support | 64 |
| conductive tracks | 66 |
| adhesive layer | 68 |
| through-holes | 70 |
| conductive ink | 72 |
| edge-to-edge transverse through-grooves | 74 |

## Claims

1. A method for producing an elongated lighting device, comprising:
- providing a coated laminate (10) including a substrate (12) and a plurality of bus tracks (14, 15) on at least one side of the substrate (12),
- applying an insulating cover layer (20) to said coated laminate (10) on said bus tracks (14), wherein said insulating cover layer (20) has a plurality of openings (24, 46, 50) through which uncovered areas (14', 14") of said bus tracks (14) are exposed,
- forming electrical circuits (26) on said insulating cover layer (20) by electrically-conductive ink printing,
- interconnecting said electrical circuits (26) to uncovered areas (14') of said bus tracks (14) through said openings (24, 46, 50), and
- applying electrically-powered light radiation sources (30) to selected areas of said electrical circuits (26).

2. A method according to claim 1, wherein said insulating cover layer (20) is formed by means of dielectric ink printing.

3. A method according to claim 1 or claim 2, comprising transversely cutting said coated laminate (10) to form single electric units (36), and applying to said single electric units (36) respective electrical connectors (52) having contact pins (54) in contact with uncovered areas (14') of said bus tracks (14).

4. A method according to claim 1 or claim 2, wherein said openings of said insulating cover layer (20) comprise:
- windows (e.g. 24) formed on the side edges of the insulating cover layer (20);
- edge-to-edge transverse through-grooves (46);
- through-holes (50) forming vertical interconnection accesses.

5. A method according to any one of the previous claims wherein said electrical circuits (26) are electrically-connected to said uncovered areas (14') of said bus tracks (14) by conductive ink branches (28) extending over said uncovered areas (14') of said bus tracks (14) through said openings (24, 46, 50).

6. A method according to any of claims 1-5, wherein said electrical circuits are electrically-connected to said uncovered areas (14') of said bus tracks (14) by means of SMD jumpers (40) connected between branches (28) of printed conductive ink on said insulating cover layer (20) and connecting formations (42) of electrically-conductive adhesive or solder paste applied to said uncovered areas (14') of said bus tracks (14).

7. A method according to any of claims 1-4, wherein said electrical circuits (26) are electrically-connected to said uncovered areas (14') of said bus tracks (14) by means of electrically-conductive adhesive tracks (44) printed between respective uncovered areas (14') of said bus tracks (14) and respective branches of electrically-conductive ink (28) printed on said insulating cover layer (20).

8. A method according to any one of the preceding claims, wherein said coated laminate (10) is a single-sided laminate.

9. A method according to any of claims 1-7, wherein said coated laminate (10) is a double-sided laminate including a substrate (12), one or more first bus tracks (14) formed on a first face of said substrate (12), and one or more second bus tracks (15) formed on a second face of said substrate (12) opposite said first face.

10. A method according to claim 9, wherein said first and second bus tracks (14, 15) are interconnected with each other by means of vertical interconnection accesses (60).

11. A method for producing an elongated lighting device, comprising:
- providing a coated laminate (10) including a substrate (12) and a plurality of bus tracks (14, 15) on at least one side of said substrate (12),
- applying a single-sided flexible printed circuit (62) to said coated laminate (10) on said bus tracks (14), wherein said single-sided flexible printed circuit (62) comprises an insulating support (64) and a plurality of conductive tracks (66) and wherein said single-sided flexible printed circuit (62) comprises a plurality of through-holes (70) forming vertical interconnection accesses,
- interconnecting said conductive tracks (66) of said single-sided flexible printed circuit (62) to said bus tracks (14) of said coated laminate (e.g. 10) by conductive ink (72) printed through said through-holes (70) of said single-sided flexible printed circuit (62), and
- applying electrically-powered light radiation sources (30) to selected areas of said conductive tracks (66) of said single-sided flexible printed circuit (62).

12. A lighting device, comprising:
- a coated laminate (10) including a substrate (12) and a plurality of bus tracks (14) on at least one side of the substrate (12),
- an insulating cover layer (20) applied to said coated laminate (10) on said bus tracks (14), wherein said cover layer (10) has a plurality of openings (24, 46, 50) through which uncovered areas (14') of said bus tracks (14) are exposed,
- an electrical circuit (26) of electrically-conductive ink printed on said insulating cover layer (20) and interconnected with said uncovered areas (14') of said bus tracks (14) through said openings (24, 46, 50), and
- a plurality of electrically-powered light radiation sources (30) applied to selected areas of said electrical circuit (26).

13. A lighting device, comprising:
- a coated laminate (10) including a substrate (12) and a plurality of bus tracks (14) on at least one side of the substrate (12),
- a single-sided flexible printed circuit (62) applied to the coated laminate (10) on said bus tracks (14), wherein said single-sided flexible printed circuit (62) comprises a substrate (64) and a plurality of conductive tracks (66) and wherein said single-sided flexible printed circuit (62) comprises a plurality of through-holes (70) forming vertical interconnection accesses,
- electrical connecting formations (72) of electrically-conductive ink printed inside said through-holes (70), which electrically connect said conductive tracks (66) of said single-sided flexible printed circuit (62) to said bus tracks (14) of said coated laminate (10), and
- a plurality of electrically-powered light radiation sources (30) connected to selected areas of said conductive tracks (66) of said single-sided flexible printed circuit (62).
